(19) Europäisches Patentamt
European Patent Office
Office européen des brevets

(11) **EP 3 717 919 B1**

(12) **FASCICULE DE BREVET EUROPEEN**

(45) Date de publication et mention
de la délivrance du brevet:
**10.06.2026 Bulletin 2026/24**

(21) Numéro de dépôt: **18808010.5**

(22) Date de dépôt: **28.11.2018**

(51) Classification Internationale des Brevets (IPC):
*B60L 3/12* (2006.01)   *B60L 53/62* (2019.01)
*B60L 58/21* (2019.01)   *G01R 31/382* (2019.01)
*G01R 31/392* (2019.01)   *G01R 31/396* (2019.01)
*H01M 10/42* (2006.01)   *H01M 10/48* (2006.01)

(52) Classification Coopérative des Brevets (CPC):
**H01M 10/482; B60L 3/12; B60L 53/62; B60L 58/21;
G01R 31/382; G01R 31/392; G01R 31/396;
H01M 10/425;** B60L 2240/54; B60L 2240/662;
B60L 2260/44; G01R 31/367; H01M 2010/4271;
H01M 2010/4278

(86) Numéro de dépôt international:
**PCT/EP2018/082864**

(87) Numéro de publication internationale:
**WO 2019/106022 (06.06.2019 Gazette 2019/23)**

(54) **PROCÉDÉ DE SURVEILLANCE ET DE GESTION D'UN PARC DE BATTERIES**

VERFAHREN ZUR ÜBERWACHUNG UND VERWALTUNG EINES BATTERIEPARKS

METHOD FOR MONITORING AND MANAGING A BATTERY PARK

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.11.2017 FR 1761276**

(43) Date de publication de la demande:
**07.10.2020 Bulletin 2020/41**

(73) Titulaire: **Commissariat à l'Energie Atomique et
aux Energies
Alternatives
75015 Paris (FR)**

(72) Inventeur: **DELAILLE, Arnaud
73000 Bassens (FR)**

(74) Mandataire: **Cabinet Camus Lebkiri
25 rue de Maubeuge
75009 Paris (FR)**

(56) Documents cités:
**EP-A1- 2 790 262       DE-A1- 102010 039 915
US-A1- 2009 189 613     US-A1- 2013 262 067
US-A1- 2015 321 576     US-A1- 2017 062 878**

## Description

### DOMAINE TECHNIQUE DE L'INVENTION

La présente invention concerne un procédé de surveillance et de gestion d'un parc de batteries.

### ARRIÈRE-PLAN TECHNOLOGIQUE DE L'INVENTION

Une batterie peut être caractérisée par des paramètres d'état, également appelés « indicateurs », et par des paramètres de gestion. L'état de charge, l'état de santé et la température de la batterie sont des exemples d'indicateurs. Les paramètres de gestion sont par exemple des seuils d'arrêt de charge et de décharge de la batterie, une valeur du courant de charge de la batterie ou encore des paramètres relatifs à la gestion thermique de la batterie.

Actuellement, ces différents paramètres caractéristiques de la batterie sont déterminés à partir de mesures effectuées sur des bancs d'essai et dans des chambres climatiques. Par exemple, pour déterminer les paramètres utilisés dans les algorithmes de calcul de l'état de charge, des tests de capacité sont réalisés dans des conditions maitrisées à différents régimes de charge et de décharge, et à différentes températures.

Cependant, cette méthode présente plusieurs inconvénients. Tout d'abord, le temps et les moyens nécessaires pour la mise en œuvre de ces mesures sont importants. De plus, les mesures sont effectuées sur des batteries neuves alors que le vieillissement des batteries a une influence sur la valeur de leurs paramètres caractéristiques. Par ailleurs, les conditions dans lesquelles les mesures sont réalisées ne permettent pas de représenter fidèlement les conditions réelles d'usage des batteries qui par nature sont aléatoires.

Un autre inconvénient est que les mesures sont effectuées sur des cellules électrochimiques individuelles alors qu'une batterie est composée de plusieurs cellules connectées en série et/ou en parallèle. Par conséquent, des différences de comportement sont attendues à l'échelle de la batterie complète. Par exemple, le comportement thermique est différent, or la température de la batterie modifie ses performances instantanées et son endurance. De plus, dans le cas de la batterie complète, la consommation de l'électronique de gestion a une influence sur l'autodécharge de la batterie, le terme d'autodécharge étant ici attribué non pas au phénomène de diminution du niveau de charge intrinsèque d'une batterie laissée au repos (liées à des réactions dites parasites) mais bien à une faible consommation de courant depuis la batterie conduisant à la diminution de son niveau de charge. Il existe aussi des problèmes de dispersion et d'équilibrage entre les cellules qui ont des effets négatifs sur les performances instantanées et l'endurance de la batterie.

En résumé, déterminer les paramètres caractéristiques d'une batterie en laboratoire demande du temps et des moyens importants et malgré cela, les valeurs ainsi obtenues diffèrent des valeurs réelles pour la batterie en cours d'usage. De plus, cet écart de valeur va s'accentuer dans le temps, à mesure du vieillissement subit par la batterie.

### RÉSUMÉ DE L'INVENTION

Il ressort de ce qui précède qu'il existe un besoin de disposer d'une méthode plus simple et plus fiable pour déterminer des paramètres caractéristiques d'une batterie.

La présente invention vise à répondre à ce besoin en proposant un procédé de surveillance et de gestion d'un parc de batteries comprenant une pluralité de batteries identiques, le procédé étant caractérisé en ce qu'il comporte les étapes suivantes :

- collecter des données relatives à une partie seulement des batteries du parc ;
- mémoriser les données collectées dans une base de données ;
- déterminer à partir des données mémorisées dans la base de données un paramètre caractéristique de chacune des batteries du parc.

L'état de la technique connaît les documents EP 2 790 262 A1 et US 2013/262067 A1 qui décrivent la surveillance des batteries de toutes les batteries disponibles dans le parc de batteries. La présente invention par contre permet de déterminer un paramètre caractéristique pour l'ensemble des batteries du parc à partir des données recueillies sur seulement une partie des batteries du parc. Le nombre de mesures nécessaires est donc minimisé, ce qui permet de gagner du temps. De plus, les mesures sont ici effectuées en conditions réelles améliorant ainsi la fiabilité du paramètre caractéristique déterminé.

Le procédé selon l'invention peut également comporter une ou plusieurs caractéristiques parmi les suivantes considérées individuellement ou selon toutes les combinaisons techniquement possibles.

Selon un mode de mise en œuvre, le procédé comporte en outre une étape de transmission du paramètre caractéristique à chacune des batteries du parc.

Selon un mode de mise en œuvre, le paramètre caractéristique est un indicateur révélateur d'un état de la batterie ou un paramètre de gestion de la batterie.

Selon un mode de mise en œuvre, le paramètre caractéristique appartient à un modèle mathématique relatif au comportement des batteries. Le paramètre caractéristique du modèle mathématique est avantageusement mis à jour au fur et à mesure que de nouvelles données sont collectées.

Selon un mode de mise en œuvre, le modèle mathématique est un modèle de vieillissement des batteries ou un algorithme de calcul de l'état de charge des batteries.

Selon un mode de mise en œuvre, le modèle mathématique est initialement défini à partir des données de référence. Un avantage est d'avoir déjà un modèle de départ pour gagner du temps.

Selon un mode de mise en œuvre, les données collectées sont sélectionnées parmi la température de charge, la température de décharge, le courant de charge, le courant de décharge et la tension aux bornes de la batterie.

Selon un mode de mise en œuvre, des données de référence sont initialement enregistrées dans la base de données et les données collectées sont comparées aux données de référence. Un avantage est de pouvoir déceler, en cas d'écart, des problèmes de conception des systèmes intégrant les batteries.

Selon un mode de mise en œuvre, les données sont collectées de manière opportuniste pendant le fonctionnement normal des batteries. Un avantage est de faciliter l'acquisition des données et de gagner du temps en n'ayant pas à effectuer une étape spécifique.

Selon un mode de mise en œuvre, les données sont collectées de manière déterministe au moyen d'un test de caractérisation de ladite partie des batteries. Un avantage est de permettre d'obtenir les données souhaitées au moment voulu.

Selon un mode de mise en œuvre, le test de caractérisation est déclenché périodiquement. Un avantage est de permettre de mettre à jour le paramètre caractéristique avec les nouvelles données collectées.

Selon un mode de mise en œuvre, le test de caractérisation est déclenché à des instants déterminés. Un avantage est de permettre de configurer des moments opportuns pour recueillir les données, c'est-à-dire des moments qui ne vont pas perturber le fonctionnement du parc. C'est le cas par exemple lorsque les batteries ne sont pas utilisées, en particulier lorsqu'elles ne sont pas sollicitées en décharge pour répondre à un besoin. Les phases de charge peuvent être considérées comme des moments opportuns dès lors qu'il est possible, dans l'intervalle de temps disponible avant la prochaine phase de décharge, d'effectuer les tests sans gêner la charge.

Selon un mode de mise en œuvre, les batteries sont sujettes à des conditions d'usage identiques, plusieurs tests de caractérisation étant déclenchés successivement sur différentes parties des batteries du parc. Un avantage est d'effectuer une rotation entre les batteries du parc pour ne pas toujours rendre indisponibles les mêmes batteries. Un autre avantage est d'homogénéiser l'impact des tests de caractérisation sur l'ensemble des batteries du parc.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1 représente schématiquement un exemple de contexte de mise en œuvre d'un procédé de surveillance et de gestion d'un parc de batteries selon l'invention ;
- la figure 2 est un diagramme fonctionnel d'un mode de mise en œuvre du procédé selon l'invention.

Les figures ne sont présentées qu'à titre indicatif et nullement limitatif de l'invention.

Pour plus de clarté, les éléments identiques ou similaires sont repérés par des signes de référence identiques sur toutes les figures.

## DESCRIPTION DÉTAILLÉE DE MODES DE MISE EN ŒUVRE DE L'INVENTION

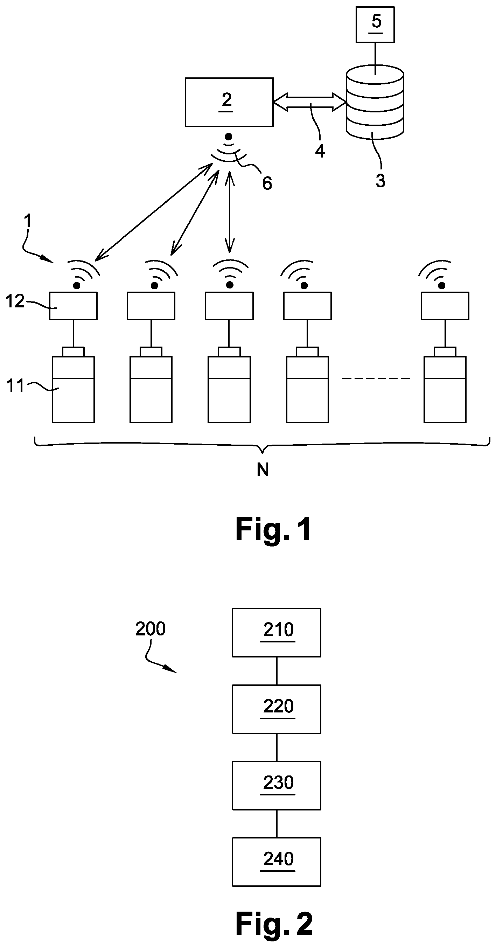

La figure 1 montre un parc de batteries 1 comportant une pluralité N de batteries 11 identiques. Chaque batterie comprend une pluralité de cellules électrochimiques connectées en série et/ou en parallèle.

On entend par « batteries identiques » des batteries fabriquées selon un même cahier des charges (i.e. des batteries de même conception, tant du point de vue électrique que mécanique), et qui sont donc supposées être identiques, ou à tout le moins similaires. Les différentes batteries 11 du parc 1 comportent donc des cellules électrochimiques de même référence.

Les batteries 11 du parc 1 peuvent être destinées à une utilisation mobile, chaque batterie 11 équipant par exemple un véhicule électrique tel qu'un vélo ou une voiture. Alternativement, les batteries 11 du parc 1 peuvent être destinées à une utilisation statique, par exemple pour concevoir des systèmes d'alimentation sans coupure, également appelées UPS pour « Uninterruptible Power Supplies » en anglais.

Les batteries 11 peuvent chacune être connectées à un point de charge (non représenté). Dans le cas par exemple d'un véhicule électrique, la batterie 11 est connectée au point de charge de manière temporaire lorsque le véhicule n'est pas utilisé. Dans le cas d'une utilisation statique, la batterie 11 peut être en permanence connectée au point de charge. Le point de charge peut être commun à tout ou partie des batteries 11, ou bien un point de charge peut être prévu pour chaque batterie 11. Le ou les points de charge comportent une source d'alimentation en énergie électrique apte à charger les batteries 11.

Dans le contexte de mise en œuvre illustré à la figure 1, chaque batterie 11 du parc 1 est équipée d'un système électronique de gestion de la batterie 12, également appelé BMS pour « Battery Management System » en anglais. Le système de gestion 12 permet de contrôler le fonctionnement de la batterie, notamment en régulant la charge et la décharge de la batterie. Le système de gestion 12 permet aussi d'effectuer des mesures sur la batterie, par exemple du courant de charge ou de décharge et de la température de la batterie. De telles batteries **11** équipées des systèmes de gestion 12 sont par exemple des batteries lithium-ion, des batteries sodium-ion ou des batteries sodium-chlorure de nickel.

Les systèmes de gestion 12 communiquent avec un dispositif de collecte 2 configuré pour collecter les données fournies par les systèmes de gestion 12. Le dispositif de collecte 2 est apte à échanger des informations avec une base de données 3 par l'intermédiaire d'une liaison de communication 4. Une interface homme-machine 5 est prévue pour consulter les données mémorisées dans la base de données 3 et pour envoyer des consignes à la base de données 3. L'interface homme-machine 5 appartient par exemple à la base de données 3.

Avantageusement, les systèmes de gestion 12 et le dispositif de collecte 2 communiquent entre eux via une liaison sans fil 6, par exemple de type Bluetooth ou en utilisant un réseau de téléphonie mobile. Ainsi, des informations relatives à une batterie 11 qui est en cours d'utilisation peuvent être transmises au système de collecte 2, même lorsque cette batterie 11 n'est pas connectée à son point de charge.

Des moyens de communication permettant une liaison filaire peuvent également ou alternativement être prévus. Il est possible d'opter pour la liaison filaire par exemple lorsque les batteries 11 ne sont pas amenées à être déplacées ou pour équiper les points de charge des véhicules électriques.

Les batteries 11 du parc 1 présentent des conditions d'usages qui peuvent être identiques ou différentes. Les conditions d'usage sont définies par différents éléments tels que les régimes de charge et de décharge auxquels les batteries 11 sont sujettes, les phases de cyclage et de repos des batteries 11 et la température environnante des batteries.

On entend par « phases de cyclage » les phases pendant lesquelles la batterie subit des cycles de charge et de décharge, c'est-à-dire les phases pendant lesquelles la batterie est utilisée. Dans ce cas la batterie est dite « en mode cyclée »

On entend par « phases de repos » les phases pendant lesquelles la batterie n'est pas utilisée. Dans ce cas la batterie est dite « en mode calendaire ».

Les batteries peuvent être disposées au même endroit ou dans des endroits différents. Dans ce dernier cas, les conditions d'usage peuvent tout de même être identiques, par exemple si les batteries 11 se trouvent chacune dans un environnement où la température ambiante est régulée à une même valeur cible.

La figure 2 représente un diagramme fonctionnel d'un procédé 200 de surveillance et de gestion du parc de batteries 1 illustré à la figure 1, selon un mode de mise en œuvre de l'invention. Le procédé 200 comporte une étape 210 de collecte de données relatives à une partie seulement des batteries 11 du parc 1. Les données sont par exemple collectées et transmises au dispositif de collecte 2 par l'intermédiaire des systèmes de gestion 12.

Le procédé selon l'invention peut également être appliqué à des batteries dépourvues de système de gestion, telles que des batteries au plomb. Dans ce cas, les données peuvent être collectées directement par le dispositif de collecte 2, par exemple au moyen d'un module de surveillance comprenant des moyens de mesures similaires à ceux des systèmes de gestion 12.

Les données collectées sont de préférence la température de la batterie pendant une charge, la température de la batterie pendant une décharge, le courant de charge, le courant de décharge et la tension aux bornes de la batterie pendant la charge et de la décharge (à un ou plusieurs instants t donnés).

Les données collectées sont ensuite mémorisées dans la base de données 3 au cours d'une étape 220 de mémorisation. Les données collectées sont ajoutées aux données déjà présentes dans la base de données 3, ces dernières provenant par exemple d'étapes de collecte antérieures.

Avantageusement, des données de référence sont initialement enregistrées dans la base de données 3, avant la mise en œuvre du procédé 200. Ces données de référence proviennent par exemple de fiches techniques fournies par le fabricant des batteries **11** ou peuvent être obtenues par des tests de caractérisation effectués préalablement sur des bancs d'essai.

Le procédé 200 comporte également une étape 230 de détermination, à partir des données présentes dans la base de données 3, d'un paramètre caractéristique des batteries 11 du parc 1. Ce paramètre caractéristique est par exemple déterminé par des moyens de calcul appartenant à la base de données 3, tel qu'un microprocesseur.

On entend par « paramètre caractéristique » un paramètre relatif à l'état ou au fonctionnement de la batterie. Le paramètre caractéristique peut être un paramètre d'état ou « indicateur », par exemple l'état de charge (SOC, pour « State Of Charge » en anglais) ou de l'état de santé (SOH, pour « State Of Health » en anglais) de la batterie. Le paramètre caractéristique peut également être un paramètre de gestion de la batterie, tel qu'un seuil d'arrêt de charge ou de décharge. Le paramètre de gestion peut aussi concerner la régulation thermique de la batterie ou la gestion des courants en fonction de l'état de charge de la batterie. Autrement, le paramètre caractéristique peut appartenir à un modèle mathématique décrivant le comportement de la batterie, comme un modèle de vieillissement de la batterie ou un algorithme de calcul de l'état de charge de la batterie.

Grâce à l'invention, il est possible de déterminer le paramètre caractéristique désiré de chaque batterie 11 du parc 1 en utilisant les données recueillies sur seulement une partie du parc 1, ce qui permet de minimiser le nombre de mesures à effectuer et donc de gagner du temps. De plus, les données collectées sont obtenues par des mesures réalisées dans des conditions réelles d'utilisation des batteries 11 ce qui permet d'améliorer la fiabilité du paramètre caractéristique déterminé. Les mesures tiennent notamment compte de l'évolution de l'état de la batterie, en particulier de son vieillissement, et de l'environnement de la batterie, ce qui n'est pas le cas dans l'art antérieur.

Un autre avantage de l'invention est de pouvoir effectuer une comparaison entre les données de références et les données réelles, un écart pouvant être révélateur d'un problème de conception du système embarquant la batterie, par exemple lié à des résistances parasites ou à un échauffement anormalement élevé.

Avantageusement, le procédé 200 comporte une étape 240 de transmission du paramètre caractéristique à chaque batterie 11 du parc 1. C'est particulièrement le cas lorsque le paramètre caractéristique est un indicateur, un paramètre de gestion de la batterie ou un paramètre d'un modèle mathématique. Ainsi, le paramètre caractéristique de chaque batterie 11 du parc 1 est mis à jour pour permettre une surveillance et une gestion optimisées des batteries 11. Il est par exemple possible de connaître précisément l'état de charge actuel de la batterie 11, et par conséquent l'autonomie du véhicule correspondant.

Les étapes 210 à 240 du procédé sont avantageusement mises en œuvre plusieurs fois pendant la vie des batteries 11, afin d'actualiser le paramètre caractéristique de chaque batterie 11.

Les données peuvent être collectées de manière opportuniste pendant le fonctionnement normal de la batterie 11, lors d'une charge ou d'une décharge (partielle ou totale). Autrement dit, les données peuvent être acquises lorsque les conditions nécessaires à leur obtention sont remplies. A titre d'exemple, l'état de santé de la batterie 11 peut être obtenu lorsque la batterie 11 effectue, au cours de son utilisation, un cycle comprenant une pleine charge (SOC = 100%) suivie d'une pleine décharge (SOC = 0%).

Les données peuvent également, ou alternativement, être collectées de manière déterministe au moyen d'un test de caractérisation de la batterie 11. Le test de caractérisation comprend de préférence une pleine charge et une pleine décharge. Ce test peut être déclenché à des intervalles de temps réguliers, par exemple tous les mois dans le cas d'application à des systèmes d'alimentation sans coupure qui sollicitent peu les batteries 11. Le test de caractérisation peut également être déclenché à des instants déterminés, par exemple lorsque le véhicule équipé de la batterie 11 est à nouveau connecté à son point de charge après son utilisation, ou inversement lorsque le véhicule est prêt à être utilisé.

Lorsque que les conditions d'usage des batteries 11 sont identiques, le test de caractérisation est avantageusement déclenché alternativement sur différentes batteries 11 du parc 1. Ainsi, en organisant une rotation entres les batteries 11 sur lesquelles les mesures sont effectuées, l'ensemble des batteries 11 du parc 1 n'est pas indisponible au même moment. De plus, le fait de procéder à une rotation entre les batteries 11 permet d'homogénéiser l'impact des tests sur l'ensemble du parc 1, et notamment en ce qui concerne le vieillissement des batteries 11.

Les données collectées peuvent provenir de différents groupes de batteries 11 soumis à des conditions d'usage différentes. La base de données 3 est ainsi enrichie avec des informations correspondant à différents cas de figures mais qui sont valables pour toutes les batteries 11. Il est ainsi possible, à partir des informations contenues dans la base de données 3, de prédire le comportement d'un groupe de batteries 11 sous des conditions d'usage auxquelles ce groupe n'a pas encore été sujet mais qui ont été subies par un autre groupe de batteries, et ce sans avoir besoin d'effectuer de nouvelles mesures.

Pour illustrer ce propos, on considère par exemple une flotte de véhicules électriques répartis en plusieurs groupes situés dans des villes différentes. Dans un tel cas, il est attendu que la température ambiante diffère d'une ville à l'autre. Grâce à la mutualisation des données, le comportement des batteries 11 peut être connu pour toutes les différentes températures déjà enregistrées dans l'ensemble des villes.

Un premier exemple d'application du procédé selon l'invention va maintenant être décrit. Ce premier exemple s'intéresse au suivi de l'état de santé des batteries 11 du parc 1 lorsqu'elles sont soumises à des conditions d'usage identiques. Dans ce cas, il est avantageusement possible d'utiliser des mesures de l'état de santé effectuées sur une partie des batteries 11 pour construire un modèle d'évolution de l'état de santé, encore appelé « modèle de vieillissement », qui soit valable pour l'ensemble des batteries 11 du parc 1. Au fur et mesure que de nouvelles données sont collectées, ce modèle peut être enrichi pour devenir plus précis.

Dans ce premier exemple d'application, un modèle générique peut initialement être paramétré à partir des données de référence présentes dans la base de données 3. Il n'est donc pas nécessaire de disposer d'un grand nombre de mesures effectuées en laboratoire puisque le modèle est bâti en cour d'usage. Les paramètres du modèle sont modifiés en fonction des nouvelles données collectées.

L'état de santé (SOH) est exprimé en pourcentage et correspond au rapport entre la capacité totale de décharge maximale $Q_{max}$ et la capacité totale initiale $Q_0$ de la batterie, cette dernière grandeur pouvant être assimilée à la capacité nominale spécifiée par le fabricant de batterie ou être mesurée.

$$\text{SOH} = \frac{Q_{max}}{Q_0}$$

La capacité de décharge maximale $Q_{max}$ représente la quantité d'énergie électrique que la batterie peut fournir lorsqu'elle est complétement chargée, à un instant donné de la vie de la batterie. La capacité totale initiale $Q_0$ est la capacité de décharge initiale de la batterie, c'est-à-dire lorsque la batterie est neuve. Plus la capacité de décharge $Q_{max}$ est proche de la capacité totale initiale $Q_0$ de la batterie, meilleur est l'état de santé de la batterie. L'état de santé est donc représentatif d'une perte irréversible d'autonomie de la batterie.

Les formules suivantes constituent un exemple de modèle de vieillissement. L'état de santé (SOH) est lié aux pertes de capacité $dQ_{loss}$ de la façon suivante :

$$\text{SOH} = \frac{Q_{max}}{Q_0} = \frac{Q_0 - dQ_{loss}}{Q_0}$$

Les pertes de capacité $dQ_{loss}$ sont définies comme la somme des pertes de capacité au repos et celles en cyclage :

$$dQ_{loss} = \frac{\partial Q_{loss}}{\partial t} dt + \frac{\partial Q_{loss}}{\partial Q_{th}} dQ_{th}$$

où :

- le terme $\frac{\partial Q_{loss}}{\partial t} dt$ représente les pertes de capacité durant les phases de repos (fonction du temps t) ;

- le terme $\frac{\partial Q_{loss}}{\partial Q_{th}} dQ_{th}$ représente les pertes de capacité durant les phases de cyclage (fonction de la quantité $Q_{th}$ d'Ah cumulés au cours des décharges successives).

Un exemple d'équation de chacune des grandeurs précédentes est donné par les formules suivantes :

$$\frac{\partial Q_{loss}}{\partial t} dt = \frac{J_{cal}}{1 + A_{cal}Q_{loss}}$$

$$\frac{\partial Q_{loss}}{\partial Q_{th}} dQ_{th} = \frac{J_{cyc}}{1 + A_{cyc}Q_{loss}}$$

où :

- $Q_{loss}$ est la capacité perdue par la batterie, exprimée en ampère-heure (Ah) ;
- $J_{cal}$ est un premier facteur d'accélération du vieillissement de la batterie en mode calendaire ;
- $J_{cycl}$ est un premier facteur d'accélération du vieillissement de la batterie en mode cyclée ;
- $A_{cal}$ est un second facteur d'accélération du vieillissement de la batterie en mode calendaire ; et
- $A_{cycl}$ est un second facteur d'accélération du vieillissement de la batterie en mode cyclée.

Les paramètres $J_{cal}$ et $A_{cal}$ dépendent de l'état de charge (SOC) et de la température (T) au repos, tandis que les paramètres $J_{cycl}$ et $A_{cycl}$ dépendent de l'état de charge (SOC) et des conditions de courant et de température lors du cyclage, autrement dit du courant de décharge $I_d$, du courant de charge $I_c$, de la température de décharge $T_d$ et de la température de charge $T_c$.

Cet exemple de modèle de vieillissement est décrit en détail dans le document [B. PILIPILI MATADI, Thèse de doctorat de l'Université de Grenoble Alpes, « Etude des mécanismes de vieillissement des batteries Li-ion en cyclage à basse température et en stockage à haute température : compréhension des origines et modélisation du vieillissement », 2017].

De manière classique, les paramètres $J_{cal}$, $A_{cal}$, $J_{cyc}$ et $A_{cyc}$ sont identifiés à partir de données d'évolution de l'état de santé (SOH) obtenues grâce à des tests réalisés en laboratoire dans différentes conditions d'usage et à l'échelle de cellules individuelles.

Dans le procédé selon l'invention, on détermine ces paramètres à partir de données collectées lors de l'utilisation des batteries du parc, permettant ainsi à la fois un gain de temps (celui des tests) et une meilleure précision (en se plaçant directement dans les conditions d'usage réel des batteries complètes et non plus des cellules individuelles).

Au préalable, des valeurs par défaut des coefficients $J_{cal}$, $A_{cal}$, $J_{cyc}$ et $A_{cyc}$ ont été enregistrées dans la base de données centralisée pour les N batteries du parc. Ces valeurs dites de référence sont par exemple obtenues à partir de données cellules/batteries fournies par le constructeur ou à partir de mesures en laboratoire.

A l'étape 210 du procédé (cf. Fig.2), on collecte des données relatives à $n$ batteries du parc ($1 \leq n < N$). Dans ce premier exemple, les données collectées sont des données d'usage - le courant de charge $I_c$, le courant de décharge $I_d$, la température de charge $T_c$, la température de décharge $T_d$ et la tension pendant la charge et la décharge - et des données d'évolution de l'état de santé (SOH). Les données d'usage permettent notamment de calculer l'état de charge (SOC). Les données d'évolution de l'état de santé sont obtenues en mesurant l'état de santé dans différentes conditions d'état de charge et de température, de préférence à intervalles réguliers (par exemple tous les trois mois).

Les données collectées sont ensuite enregistrées dans la base de données centralisée lors de l'étape 220.

A l'étape 230, on calcule les coefficients $J_{cal}$, $A_{cal}$, $J_{cyc}$ et $A_{cyc}$ du modèle de vieillissement à partir des données collectées, en réalisant par exemple un ajustement (« fit ») de courbes (les paramètres $J_{cal}$, $A_{cal}$, $J_{cyc}$ et $A_{cyc}$ sont liés au SOH par l'intermédiaire de $dQ_{loss}$ et dépendent des données d'usage et du SOC). Ce calcul peut faire appel à des traitements statistiques des données collectées, notamment pour pondérer des données aberrantes et/ou réduire le temps de traitement.

Les valeurs des paramètres $J_{cal}$, $A_{cal}$, $J_{cyc}$ et $A_{cyc}$ stockées dans la base de données sont remplacées par celles obtenues à l'étape S3, puis transmises à chaque batterie du parc lors de l'étape 240 (par exemple pour être enregistrées dans une mémoire du système électronique de gestion).

Les étapes 210 à 240 sont avantageusement répétées pour affiner l'identification des paramètres du modèle (nouvelles conditions d'usage collectées et/ou nouvelles valeurs d'état de santé collectées).

A partir d'un tel modèle de vieillissement, il est possible de faire de la maintenance prédictive en déterminant notamment à quel moment remplacer les batteries 11.

Un deuxième exemple d'application du procédé selon l'invention va maintenant être décrit. Ce deuxième exemple s'intéresse à la détermination des paramètres d'un algorithme de calcul de l'état de charge des batteries 11 lorsqu'elles sont soumises à des conditions d'usage différentes. Pour cela, il est nécessaire de connaître la capacité disponible en fonction des paramètres de fonctionnement tels que le régime de courant et la température. L'état de santé ayant été mesuré par ailleurs, il est possible de reconstituer à partir des données provenant de différentes batteries utilisées dans différentes conditions une cartographie de l'autonomie en fonction des conditions d'usage.

L'état de charge de la batterie (SOC, exprimé en pourcentage) peut être déterminé à partir des équations suivantes :

$$ SOC = \frac{Q_{max}(I_{ref}, T_{ref}) - Q_d + Q_c}{Q_{max}(I_{ref}, T_{ref})} \times 100 $$

$$ Q_d = \alpha(I_d, T_d) . I_d . t $$

$$ Q_c = \beta(I_c, T_c) . I_c . t $$

où :

- $I_{ref}$ et $T_{ref}$ sont respectivement le courant et la température pris comme valeur de référence (par exemple $T_{ref} = 25°C$ et $I_{ref} = Q_n/2$ avec $Q_n$ la capacité nominale de la batterie) ;
- $Q_{max}(I_{ref}, T_{ref})$ est la capacité maximale de la batterie (en Ah) après une charge complète de la batterie au courant $I_{ref}$

et à la température $T_{ref}$ (Qmax varie en fonction du SOH) ;

- $Q_d$ est la capacité déchargée, exprimée en ampère-heure (Ah), au cours d'une phase de décharge effectuée à un courant $I_d$ et à une température $T_d$ ;
- $Q_c$ est la capacité chargée, exprimée en ampère-heure (Ah), au cours d'une phase de charge effectuée à un courant $I_c$ et à une température $T_c$ ;
- $\alpha$ et $\beta$ sont des coefficients d'équivalence respectivement de décharge et de charge, autrement dit des coefficients permettant de prendre en compte l'incidence des conditions de courant et de température de fonctionnement sur respectivement la capacité disponible en décharge ou admissible en charge ; et
- t est une période de temps donnée.

Cet exemple d'algorithme d'état de charge est décrit en détail dans le document [A. DELAILLE, Thèse de doctorat de l'Université de Paris 6, « Développement de méthodes d'évaluation de l'état de charge et de l'état de santé des batteries utilisées dans les systèmes photovoltaïques », 2006].

De manière classique, les coefficients $\alpha$ et $\beta$ de l'algorithme d'état de charge sont déterminés à partir des relations suivantes, en effectuant des tests de capacité en laboratoire sur des cellules individuelles sous différentes conditions de courant et de température et à un seul état de santé (SOH = 100 %).

$$\alpha = \frac{Q_{max}\left(I_{ref}, T_{ref}\right)}{Q_{max}(I_d, T_d)}$$

$$\beta = \frac{Q_{max}\left(I_{ref}, T_{ref}\right)}{Q_{max}(I_c, T_c)}$$

$Q_{max}(I_{ref}, T_{ref})$ est l'intégrale du courant de référence $I_{ref}$ pendant une décharge ou une charge complète de la batterie à la température de référence $T_{ref}$. $Q_{max}(I_c, T_c)$ est l'intégrale du courant de décharge $I_d$ pendant une décharge complète de la batterie à la température de charge $T_d$. $Q_{max}(I_c, T_c)$ est l'intégrale du courant de charge $I_c$ pendant une charge complète de la batterie à la température de charge $T_c$.

En pratique, les coefficients $\alpha$ et $\beta$ sont des matrices de valeurs qui ne dépendent respectivement que des grandeurs $I_d$, $T_d$ et $I_c$, $T_c$ ($I_{ref}$, $T_{ref}$ et $Q_{max}(I_{ref}, T_{ref})$ ayant été préalablement déterminés). Il suffit donc de collecter plusieurs couples de valeurs $I_d$, $T_d$ pour déterminer $\alpha$ et plusieurs couples de valeurs $I_c$, $T_c$ pour déterminer $\beta$.

Dans le procédé selon l'invention, on détermine les coefficients $\alpha$ et $\beta$ à partir de ces mêmes relations et de données collectées directement lors de l'utilisation des batteries du parc, permettant ainsi à la fois un gain de temps (celui des tests en laboratoire) et une meilleure précision (en se plaçant dans les conditions d'usage réel des batteries entières, et non plus des cellules individuelles, et en considérant en outre l'état de santé des batteries).

Au préalable, des valeurs par défaut des coefficients $\alpha$ et $\beta$ ont été enregistrées dans la base de données centralisée pour les N batteries du parc. Ces valeurs dites de référence sont par exemple obtenues à partir de données cellules/batteries fournies par le constructeur ou à partir de mesures en laboratoire (pour SOH = 100 %).

Puis, à l'étape 210 (cf. Fig.2), on collecte des données relatives à n batteries du parc ($1 \leq n < N$), ces n batteries étant soumises à des conditions de courant et de température différentes. Les données sont collectées une première fois en début de vie (SOH = 100 %, soit $Q_{max} = Q_0$) pendant une pleine charge et pendant une pleine décharge. Dans ce deuxième exemple, les données collectées sont les conditions de courant et de température $I_d$, $T_d$ lors de la décharge, les conditions de courant et de température $I_c$, $T_c$ lors de la charge et la tension aux bornes de la batterie lors de la décharge et de la charge.

Les données collectées sont ensuite enregistrées dans la base de données centralisée lors de l'étape 220.

A l'étape 230, on calcule les coefficients $\alpha$ en décharge et $\beta$ en charge de la jauge d'état de charge des n batteries à partir des données collectées. Ce calcul peut faire appel à des traitements statistiques des données collectées, notamment pour pondérer des données aberrantes et/ou réduire le temps de traitement.

Les valeurs des paramètres $\alpha$ et $\beta$ stockées dans la base de données sont remplacées par celles obtenues à l'étape S3, puis transmises à chaque batterie du parc lors de l'étape 240 (par exemple pour être enregistrées dans une mémoire du système électronique de gestion). Grâce au procédé selon l'invention, l'état de charge de n'importe quelle batterie du parc peut désormais être déterminé avec précision.

Les étapes 210 à 240 sont avantageusement répétées pour de nouvelles données collectées ultérieurement au même état de santé ou encore pour d'autres valeurs d'état de santé. Avant chaque répétition, la capacité maximale de la batterie $Q_{max}(I_{ref}, T_{ref})$ est avantageusement requalifiée en effectuant une pleine charge et une pleine décharge au courant de référence $I_{ref}$ et à la température de référence $T_{ref}$.

# EP 3 717 919 B1

Naturellement, l'invention n'est pas limitée aux modes de mise en œuvre décrits en référence aux figures. L'invention est toutefois définie par les revendications annexées.

## Revendications

1. Procédé (200) de surveillance et de gestion d'un parc de batteries (1) comprenant une pluralité de batteries (11) identiques, le procédé (200) étant **caractérisé en ce qu'**il comporte les étapes suivantes :

   - (210) collecter des données relatives à une partie seulement des batteries (11) du parc (1) ;
   - (220) mémoriser les données collectées dans une base de données (3) ;
   - (230) déterminer à partir des données mémorisées dans la base de données (3) un paramètre caractéristique de chacune des batteries (11) du parc (1).

2. Procédé (200) selon la revendication 1, **caractérisé en ce qu'**il comporte en outre une étape (240) de transmission du paramètre caractéristique à chacune des batteries (11) du parc (1).

3. Procédé (200) selon l'une des revendications 1 et 2, **caractérisé en ce que** le paramètre caractéristique est un indicateur révélateur d'un état de la batterie (11) ou un paramètre de gestion de la batterie (11).

4. Procédé (200) selon l'une des revendications 1 et 2, **caractérisé en ce que** le paramètre caractéristique appartient à un modèle mathématique relatif au comportement des batteries (11), le paramètre caractéristique du modèle mathématique étant mis à jour au fur et à mesure que de nouvelles données sont collectées.

5. Procédé (200) selon la revendication 4, dans lequel le modèle mathématique est un modèle de vieillissement des batteries (11) ou un algorithme de calcul de l'état de charge des batteries (11).

6. Procédé (200) selon l'une des revendications 4 et 5, **caractérisé en ce que** le modèle mathématique est initialement défini à partir de données de référence.

7. Procédé (200) selon l'une quelconque des revendications 1 à 6, **caractérisé en ce que** les données collectées sont sélectionnées parmi la température de charge, la température de décharge, le courant de charge, le courant de décharge et la tension aux bornes de la batterie.

8. Procédé (200) selon l'une quelconque des revendications 1 à 7, **caractérisé en ce que** des données de référence sont initialement enregistrées dans la base de données (3) et **en ce que** les données collectées sont comparées aux données de référence.

9. Procédé (200) selon l'une quelconque des revendications 1 à 8, caractérisé en que les données sont collectées de manière opportuniste pendant le fonctionnement normal des batteries (11).

10. Procédé (200) selon l'une quelconque des revendications 1 à 8, caractérisé en que les données sont collectées de manière déterministe au moyen d'un test de caractérisation de ladite partie des batteries (11).

11. Procédé (200) selon la revendication 10, **caractérisé en ce que** le test de caractérisation est déclenché périodiquement.

12. Procédé (200) selon l'une des revendications 10 et 11, **caractérisé en ce que** le test de caractérisation est déclenché à des instants déterminés.

13. Procédé (200) selon l'une quelconque des revendications 10 à 12, **caractérisé en ce que** les batteries (11) sont sujettes à des conditions d'usage identiques, plusieurs tests de caractérisation étant déclenchés successivement sur différentes parties des batteries (11) du parc (1).

14. Procédé (200) selon l'une quelconque des revendications 1 à 13, **caractérisé en ce que** les données collectées proviennent de différents groupes de batteries (11) soumis à des conditions d'usage différentes.

**Patentansprüche**

1. Verfahren (200) zur Überwachung und Verwaltung eines Batterieparks (1), der eine Vielzahl identischer Batterien (11) umfasst, wobei das Verfahren (200) **dadurch gekennzeichnet ist, dass** es die folgenden Schritte umfasst:

   - (210) Erfassen von Daten, die sich nur auf einen Teil der Batterien (11) des Batterieparks (1) beziehen;
   - (220) Speichern der erfassten Daten in einer Datenbank (3);
   - (230) Bestimmen eines charakteristischen Parameters jeder der Batterien (11) des Batterieparks (1) anhand der in der Datenbank (3) gespeicherten Daten.

2. Verfahren (200) nach Anspruch 1, **dadurch gekennzeichnet, dass** es ferner einen Schritt (240) zum Übertragen des charakteristischen Parameters an jede der Batterien (11) des Batterieparks (1) umfasst.

3. Verfahren (200) nach einem der Ansprüche 1 und 2, **dadurch gekennzeichnet, dass** der charakteristische Parameter ein Indikator für einen Zustand der Batterie (11) oder ein Parameter zur Steuerung der Batterie (11) ist.

4. Verfahren (200) nach einem der Ansprüche 1 und 2, **dadurch gekennzeichnet, dass** der charakteristische Parameter zu einem mathematischen Modell gehört, das sich auf das Verhalten der Batterien (11) bezieht, wobei der charakteristische Parameter des mathematischen Modells aktualisiert wird, sobald neue Daten erfasst werden.

5. Verfahren (200) nach Anspruch 4, bei dem das mathematische Modell ein Alterungsmodell für Batterien (11) oder ein Algorithmus zur Berechnung des Ladezustands der Batterien (11) ist.

6. Verfahren (200) nach einem der Ansprüche 4 und 5, **dadurch gekennzeichnet, dass** das mathematische Modell anfänglich anhand von Referenzdaten definiert wird.

7. Verfahren (200) nach einem der Ansprüche 1 bis 6, **dadurch gekennzeichnet, dass** die erfassten Daten aus der Ladetemperatur, der Entladetemperatur, dem Ladestrom, dem Entladestrom und der Batteriespannung ausgewählt werden.

8. Verfahren (200) nach einem der Ansprüche 1 bis 7, **dadurch gekennzeichnet, dass** Referenzdaten zunächst in der Datenbank (3) gespeichert werden und dass die erfassten Daten mit den Referenzdaten verglichen werden.

9. Verfahren (200) nach einem der Ansprüche 1 bis 8, **dadurch gekennzeichnet, dass** die Daten während des normalen Betriebs der Batterien (11) opportunistisch erfasst werden.

10. Verfahren (200) nach einem der Ansprüche 1 bis 8, **dadurch gekennzeichnet, dass** die Daten deterministisch mittels eines Charakterisierungstests des genannten Teils der Batterien (11) erfasst werden.

11. Verfahren (200) nach Anspruch 10, **dadurch gekennzeichnet, dass** der Charakterisierungstest periodisch ausgelöst wird.

12. Verfahren (200) nach einem der Ansprüche 10 und 11, **dadurch gekennzeichnet, dass** der Charakterisierungstest zu festgelegten Zeitpunkten ausgelöst wird.

13. Verfahren (200) nach einem der Ansprüche 10 bis 12, **dadurch gekennzeichnet, dass** die Batterien (11) identischen Nutzungsbedingungen ausgesetzt sind, wobei mehrere Charakterisierungstests nacheinander an verschiedenen Teilen der Batterien (11) des Batterieparks (1) ausgelöst werden.

14. Verfahren (200) nach einem der Ansprüche 1 bis 13, **dadurch gekennzeichnet, dass** die erfassten Daten von verschiedenen Gruppen von Batterien (11) stammen, die unterschiedlichen Nutzungsbedingungen ausgesetzt sind.

**Claims**

1. A method (200) for monitoring and managing a battery fleet (1) comprising a plurality of identical batteries (11), the method (200) being **characterised in that** it includes the following steps:

- (210) collecting data relating to only part of the batteries (11) in the fleet (1);
- (220) storing the data collected in a database (3);
- (230) determining, from the data stored in the database (3), a characteristic parameter of each of the batteries (11) in the fleet (1).

2. The method (200) according to claim 1, **characterised in that** it further includes a step (240) of transmitting the characteristic parameter to each of the batteries (11) in the fleet (1).

3. The method (200) according to one of claims 1 and 2, **characterised in that** the characteristic parameter is an indicator revealing a state of the battery (11) or a management parameter of the battery (11).

4. The method (200) according to one of claims 1 and 2, **characterised in that** the characteristic parameter belongs to a mathematical model relating to the behaviour of the batteries (11), the characteristic parameter of the mathematical model being updated as new data are collected.

5. The method (200) according to claim 4, wherein the mathematical model is an ageing model of the batteries (11) or an algorithm for calculating the state of charge of the batteries (11).

6. The method (200) according to one of claims 4 and 5, **characterised in that** the mathematical model is initially defined from reference data.

7. The method (200) according to any of claims 1 to 6, **characterised in that** the data collected are selected from the charge temperature, the discharge temperature, the charge current, the discharge current and the voltage across the battery.

8. The method (200) according to any of claims 1 to 7, **characterised in that** reference data are initially recorded in the database (3) and **in that** the data collected are compared with the reference data.

9. The method (200) according to any of claims 1 to 8, **characterised in that** the data are collected opportunistically during normal operation of the batteries (11).

10. The method (200) according to any of claims 1 to 8, **characterised in that** the data are collected deterministically by means of a characterisation test of said part of the batteries (11).

11. The method (200) according to claim 10, **characterised in that** the characterisation test is periodically triggered.

12. The method (200) according to one of claims 10 and 11, **characterised in that** the characterisation test is triggered at predetermined instants.

13. The method (200) according to any of claims 10 to 12, **characterised in that** the batteries (11) are subject to identical usage conditions, with several characterisation tests being successively triggered on different parts of the batteries (11) in the fleet (1).

14. The method (200) according to any of claims 1 to 13, **characterised in that** the data collected are derived from different groups of batteries (11) subjected to different usage conditions.

EP 3 717 919 B1

**Fig. 1**

**Fig. 2**

**EP 3 717 919 B1**

## RÉFÉRENCES CITÉES DANS LA DESCRIPTION

**Documents brevets cités dans la description**

- EP 2790262 A1
- US 2013262067 A1